(19) **Europäisches Patentamt**

**European Patent Office**

**Office européen des brevets**

(11) **EP 1 088 240 B1**

(12) **EUROPEAN PATENT SPECIFICATION**

(45) Date of publication and mention
of the grant of the patent:
**05.04.2006 Bulletin 2006/14**

(51) Int Cl.:
***G01R 31/36*** *(2006.01)*    ***G01R 19/165*** *(2006.01)*

(21) Application number: **99926967.3**

(22) Date of filing: **15.06.1999**

(86) International application number:
**PCT/KR1999/000304**

(87) International publication number:
**WO 1999/066340 (23.12.1999 Gazette 1999/51)**

(54) **METHOD OF AND APPARATUS FOR MEASURING BATTERY CAPACITY**

VERFAHREN UND VORRICHTUNG ZUR MESSUNG DER KAPAZITÄT EINER BATTERIE

PROCEDE ET APPAREIL POUR LA MESURE DE LA CAPACITE D'UNE BATTERIE

(84) Designated Contracting States:
**AT BE CH CY DE DK ES FI FR GB GR IE IT LI LU MC NL PT SE**

(30) Priority: **16.06.1998 KR 9822540**
**25.06.1998 KR 9824134**

(43) Date of publication of application:
**04.04.2001 Bulletin 2001/14**

(73) Proprietor: **Korea Kumho Petrochemical Co. Ltd.**
**Chongno-ku,**
**Seoul 110-110 (KR)**

(72) Inventors:
• **YOON, Chul, Oh**
**Yousung-ku,**
**Taejeon-city 305-345 (KR)**

• **BARSUKOV, Yevgen**
**Taejeon-city 305-345 (KR)**
• **KIM, Jong, Hyun**
**Seoul 142-108 (KR)**

(74) Representative: **Nash, David Allan**
**HASELTINE LAKE,**
**Redcliff Quay**
**120 Redcliff Street**
**Bristol BS1 6HU (GB)**

(56) References cited:
**EP-A1- 0 146 377     FR-A1- 2 691 260**

• **JP 06-337 284 A (OMRON CORP); (abstract), 28 April 1995, In: Patent Abstract of Japan [CD-Rom]**

## Description

### Technical Field

The present invention relates to a method of and apparatus for determining an unknown capacity of a battery by applying current or voltage to a primary and secondary battery and by measuring and analyzing an output signal based on an applied input signal. More particularly, it relates to a method of and apparatus for measuring battery capacity using parameters obtained from a voltage response signal of a current wave form or an impedance spectrum generated thereof which provide a nondestructive measurement of battery capacity, for measuring an unknown remaining capacity of a standardized battery product, or in case of a manufacturing, grading the rated capacity of the batteries.

### Background Art

A general method used for measuring battery capacity includes a real-time discharge method, which is to measure the discharge time $t_d$ for a consumption of electrical energy by the battery at a constant current $I_d$.

If the capacity is expressed in ampere-hour (Ah), the discharge time $t_d$ that a battery supplies electrical energy is given by Equation I, which is used as the standard for evaluating battery capacity, for example, the Korean Industrial Standards.

$$[\text{Equation 1}]$$

$$t_d = Ah / I_d$$

A real-time discharge method is one for measuring battery capacity in a direct way and takes a long time throughout the entire discharge period in real time.

Also, it is necessary to use a plurality of apparatuses in order to discharge multiple batteries independently if the user has to measure plural batteries in a simultaneous manner. This results in a reduction of production efficiency in manufacturing of batteries.

Especially, for the primary battery, the real-time discharge method is inapplicable to the measurement of battery for purpose of duality control of products.

A more efficient method used for measuring battery capacity is one that enables a measurement of the battery characteristics for a short time relative to the discharge period of the battery in real-time, as a result of which precise information can be obtained concerning charge/discharge condition or remaining capacity of the battery.

In regards to the method characterizing the state of charge/discharge of battery, measurements of open circuit voltage, voltage and its variations in battery operation, output signal characteristic responsive to input voltage or current applied to battery, and thereby induced internal resistance or impedance function are generally known.

A use of these various methods provides a measurement of battery capacity for a short time relative to a real-time discharge method.

It is however necessary to provide a precise correlation between the measured value and the actual capacity in order to obtain battery capacity in the above-stated methods.

U.S. Patent No. 3.808.487 discloses a method for sensing the charge condition of a storage battery with a response signal based on a pulse signal which has been periodically applied to the battery during charging.

According to the method, information concerning the charge condition and battery capacity is not extracted from the response signal but by a detection of changes in the measured signal, which is expected at the end point of charge.

In another method stated in U.S. Patent No. 4,952,862, the remaining capacity can be calculated from the measured voltage and the discharge characteristic which is expressed in voltage-hour function including the Peukert parameter.

Especially, EP 119.547 discloses a method used for measuring discharge voltage as a function of time and determining the discharge condition from the averaged change rate of discharge voltage in a predetermined time interval.

When calculating the capacity from a measured voltage and its variants as described above, a precision of the correlation between the measured value and battery capacity is strongly dependant upon the discharge characteristic.

For instance, a battery having a plateau of voltage provides extremely small variations in the voltage against a change of discharge condition.

Therefore, the method is not considered to be a proper measurement for sensing the discharge condition of a battery.

In order to use a method disclosed in EP 119.547. the measurement time or discharge current should increase to enhance the precision of a correlation between the measured value and battery capacity, which obviously reduces the efficiency of measurement.

For a close correlation with battery capacity, it is very important to measure battery characteristics related to physical or chemical parameters highly influenced by the charge/discharge condition of battery, such as internal resistance or impedance.

There has already been reported a method of determining remaining capacity of battery or monitoring battery battery charging discharging state by measuring internal resistance or impedance at a specified frequency or specified frequency range to measure characteristics related to kinetic parameters of battery.

US Patent No. 3,562,634 describes a method for determining the state of charge a secondary battery, especially nickel-cadmium battery, from the measured Faraday capacitance by using a bridge. According to US Patent No. 3,562,634, the relationship between the internal impedance of battery and the battery capacity substantially depends on the impedance response characteristic of chemical material used as an active material of the battery.

Therefore the specific relationship between the internal impedance of battery and the battery capacity measured at a specified frequency and for a specified kind of battery do not generally apply to determining battery capacity.

U.S. Patent No. 4,678,998 describes a method for examining the charge/discharge condition of battery using a correlation between the remaining capacity and the internal impedance at a specified frequency. This method has been proposed for the users to determine the charge/discharge condition of an automobile battery continuously.

Besides. US Patent No. 4,743,855 describes a method of using two complex impedances separately measured in the lower and higher frequency regions, and US Patent Nos. 5,241,275 and 5,717,336 disclose the use of the linear impedance characteristic in the lower frequency region. However, the related art method using the relationship between battery capacity and impedance at a specified frequency or in a narrow frequency region is hardly excellent in aspects of efficiency of measurement and accuracy of correlation.

Impedance characteristic of battery can be expressed as a simple equivalent circuit composed of several resistors, capacitors and transmission lines, and the value of model parameters of the equivalent circuit can be calculated from the measured impedance spectrum.

Generally, an impedance of a battery having a close correlation with the charge/discharge condition of a battery is observed at a low frequency of several mHz, so the proposed equivalent circuit model can be reduced to a simple circuit valid in low frequency region.

According to the present invention, values of parameters are determined by measuring a voltage response upon applied current waveform and subsequent fitting of time domain function of proposed equivalent circuit to the data, or alternatively converting the time domain response into frequency domain impedance data and then fitting complex function of equivalent circuit to this data.

A method using pulse signals provides the same model parameters as obtained in an impedance spectrum measurement method to determine equivalent circuit impedance model parameters at low frequencies.

The present invention uses a simple apparatus including a current generator for applying a current waveform, a voltmeter for measuring the output voltage, a control unit of the voltmeter, and an algorithm, as a result of which a similar time is taken in a measurement but more efficiency can be provided than the above-mentioned conventional methods.

Especially, the present invention presents a greatly efficient method and apparatus to be used in a manufacturing of battery products, since when measuring a plurality of batteries at the same time, a charging/discharging device used in measuring battery capacity in a real time can be reuscd or used after slight modification.

## Disclosurc of Invention

Accordingly, an object of the present invention is to provide a method of and apparatus for measuring an unknown battery capacity by measuring voltage response upon applied current waveform and determining parameters correlating with battery capacity either directly from voltage response or after its conversion to frequency dependent impedance, which take less time than the real-time discharge method and is excellent in efficiency and reliability.

According to a first aspect of the present invention, as claimed in claim 1, there is provided a method for measuring battery capacity, characterised in that the method comprises the steps of: measuring, as a function of time, a voltage or current response signal resulting from the application of a current or voltage excitation signal to both ends of a battery; analyzing the measured signal to determine a parameter or parameters of a predefined impedance model of the battery; examining a correlation between the parameter or parameters and the capacity of the battery measured by a real-time discharge method; and based on the correlation, determining the capacity of the battery from the parameter or parameters.

According to a second aspect of the present invention as claimed in claim 16, there is provided an apparatus for measuring a capacity of a battery, characterised in that the apparatus comprises: control means adapted to: generate either (i) a perturbation signal comprising a combination of non-overlapping sine waves with selected frequencies, or (ii) a pulse signal; transfer the generated signal as a control signal to measuring means; receive a time-varying response signal detected by the measuring means; analyze the response signal to obtain a parameter or parameters of a predefined impedance model of the battery; correlate the parameter or parameters and the capacity of the battery measured by a real-time discharge method; and determine the capacity of the battery based on the correlation; measuring means adapted to: apply the generated perturbation signal or pulse signal to a test battery; detect the time-varying current and voltage response signals of the test battery; and transmit the response signal to the control means.

The present invention takes a shorter time than a real-time discharge method and delivers efficiency and reliability in determining model parameters of an equivalent circuit which are in close correlation with the charge/discharge condition of the battery.

It is to be understood that both the foregoing general description and the following detailed description are exemplary and explanatory and are intended to provide further explanation of the invention as claimed.

**Brief Description of Drawings**

FIGS. 1a-1c are circuit diagrams of equivalent circuits having model parameters related to the electrochemical reaction of a battery;

FIG. 2 is a graph showing impedance spectrum experimentally measured and fitted to the equivalent circuit valid in low frequency region shown in FIG. 1a;

FIG. 3 is a graph showing the characteristic impedance spectrum measured of lithium ion battery and fit by equivalent circuit model;

FIG. 4 is an equivalent circuit diagram of a a transmission line model;

FIG. 5 is a graph showing a measured voltage response curve resulting from an applied current pulse measured on a nickel-metal hydride battery and fit by time domain response function of equivalent circuit valid in low frequency region.

FIG. 6 is a block diagram of a measurement apparatus in accordance with the present invention;

FIG. 7 is a graph showing a correlation between the remaining capacity of a lithium ion battery and selected model parameter;

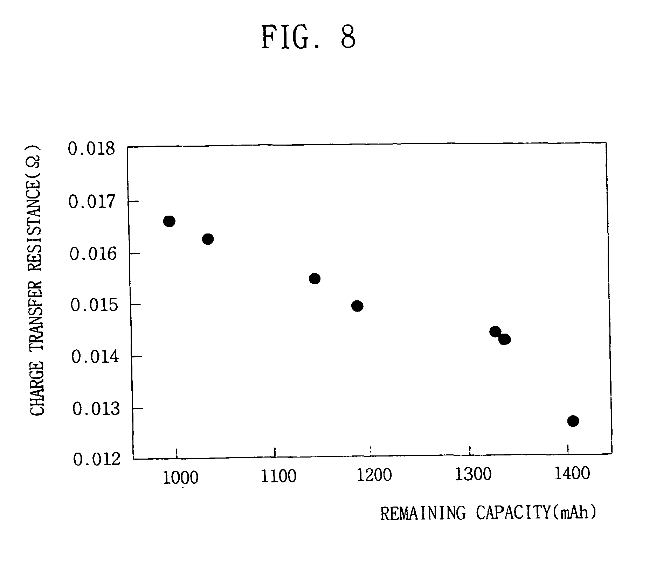

FIG. 8 is a graph showing a correlation between the discharge capacity of a fully charged lithium ion battery and selected model parameter: obtained from battery in fully changed state;

FIG. 9 is a graph a correlation between the remaining capacity of a lithium ion battery and impedances at frequencies of 5 mHz and 60 Hz;

FIG. 10 is a graph a correlation between the remaining capacity of a lithium ion battery and the frequency dependence of impedance in the lower frequency region;

FIGS. 11a and 11b are graphs showing a correlation between model parameters and the remaining capacity of a nickel metal hydride battery during discharge;

FIGS. 12a and 12b are graphs showing a correlation between inodel parameters and the remaining capacity of a lithium ion battery during discharge; and

FIG. 13 is a graph showing a correlation between model parameters and the remaining capacity of a lithium ion battery in a full charged condition.

**Best Mode for Currying out the Invention**

Hereinafter, a method of and apparatus for measuring battery capacity according to the present invention will be described with reference to the accompanying drawings.

Model parameters determined in this invention either directly from voltage response or after its conversion into impedance can be considered as follows, which have a correlation with capacity in the electrochemical reaction of an electrode active material related to the charge/discharge condition.

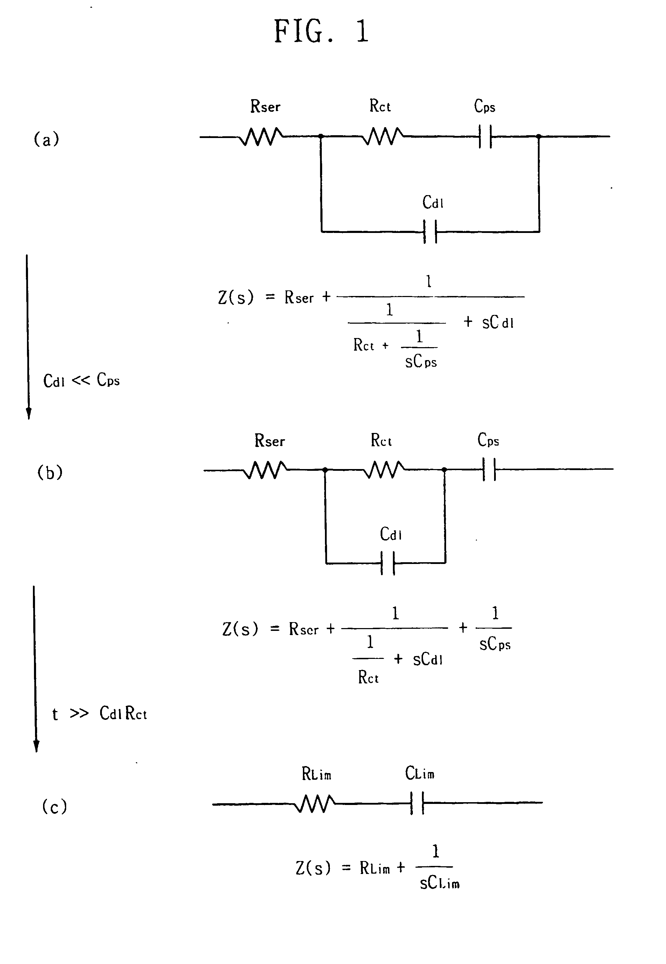

As shown in FIG. 1a, the surface impedance $Z_i$, of substance A adsorbed to the surface of an electrode in an oxidation/reduction reaction A - e = A can be expressed with a simple equivalent circuit model, which is composed of charge transfer resistance $R_{er}$, pseudocapacitance $C_{ps}$, double layer capacitance $C_{dl}$, and serial resistance $R_{ser}$ contributed by resistance of electrolyte and wires.

Pseudocapacitance $C_{ps}$ is given by equation 2:

[Equation 2]

$$C_{ps} = \frac{S \cdot F \cdot z}{dE/dc}$$

where S is the surface area of the electrode. F is the Faraday constant. z is the number of migrating charges, and dE/dc is a potential-concentration coefficient.

Using the Nernst equation in Equation 2, we write Equation 3:

[Equation 3]

$$C_{ps} = \frac{F^2 c_0 z}{RT} \cdot \frac{\exp\{\frac{zF}{RT}(E - E_0)\}}{\exp\{\frac{zF}{RT}(E - E_0)\} + 1}$$

where $c_0$ is the equilibrium concentration of species related to the redox reaction. E is electrochemical potential in the charge/dischage state or battery, $E_0$ is electrochemical potential in the equilibrium state. R is gas constant and T is temperature, respectively.

The pseudocapacitance $C_{ps}$ is a model parameter related to the amount of redox species. The reaction mechanism may be more complicated in an actual battery because the species are not simply adsorbed to the electrode surface but distributed in the space of a porous electrode material. But, it can be approximated to an electrode adsorption model at a low frequency of several mHz, so that the pseudocapacitance can be obtained from a relationship with the imaginary part of the complex impedance at the low frequency. The relationship can be expressed by:

$$Z'' = \frac{1}{\omega} C_{ps}$$

where $\omega$ is $2\pi f$.

An application of such a model parameter related to the impedance spectrum has been described in detail by C. Ho. I. R. Raistrick. R. A. Huggins. J. Electrochem. Soc. 127. 343 (1980).

As a measurement for the complex impedance, the Fourier transform method is used by applying a perturbation current signal galvanostatically to both terminals of battery to be measured and by Fourier-transforming a recorded voltage response signal in time domain to frequency domain.

In a preferred embodiment, the ratio of the highest and lowest frequencies in the frequency domain is at least 100.

Preferably, the time required to measure the voltage characteristic in response to the excitation signal is less than 1/10 of the full discharge time at a given current or voltage calculated from a rated battery capacity.

The perturbation current signal used as an input signal is generated by superposition of multiple sinusoidal waves corresponding to multiply selected frequencies. If the lowest frequency is $f_{min}$, for example, the oscillation current signal can be composed of $3f_{min}$, $5f_{min}$, $7f_{min}$ and the like.

Preferably, the excitation signal is a combination of non-overlapping sine-waves having selected frequencies, and the excitation signal can be transformed into the frequency domain so that the ratio between the amplitude of a wave at a selected frequency to the amplitude of a wave at another frequency is more than 100.

The finite multiple frequency Fourier transform method is different from that using pulses (US Patent No. 5633801).

Preferably, a fast Fourier transform is used to obtain impedance spectra from the measured response signal.

Alternatively, when the applied signal is a current or voltage pulse, a Laplace transform is used to obtain the impedance spectra.

The principle of the measurement is disclosed by G. S. Popkirov and R. N. Schindler, Rev. Sci. Instrum., 63, 5366 (1992).

The maximum frequency that can be determined by the Fourier transform impedance measurement using multiple frequencies is limited by the sampling time of a signal recorder. The perturbation current is applied for two cycles of the lowest frequency and only the second cycle data are used in the analysis in order to avoid transient effect in the lower frequency region.

Compared with a method using frequency response analyzer which employs single frequency perturbation signal, the time required for measuring impedance by Fourier transform reduced by more than about 1/2.

When impedance spectrum is by Fourier transform method, it is possible to determine the linearity of the measurement system with respect to the current applied to the battery by comparing magnitudes of complex voltages at applied frequencies and those detected at unselected frequencies.

This is also an advantage of the Fourier transform impedance measurement, by which the errors of the measurement can be checked and obtained at the same time as the impedance measurement.

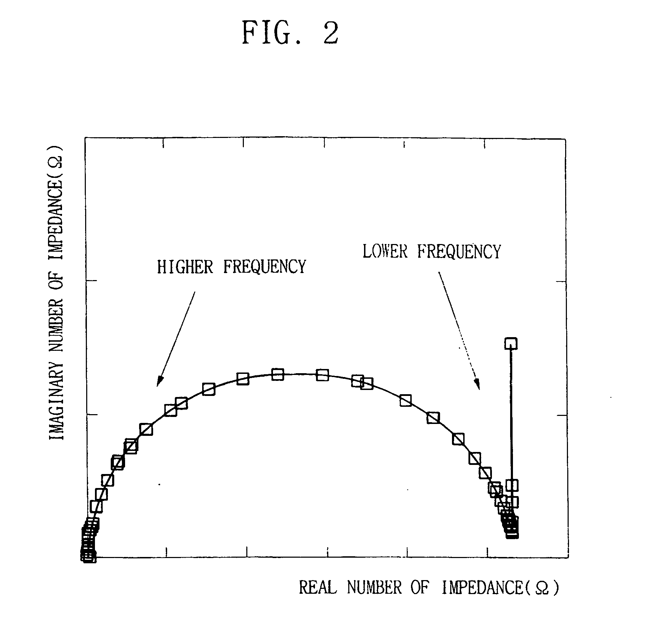

Actually, the impedance spectrum of battery measured as a function of frequency usually differs from the case of ideal interfacial adsorption as illustrated in FIG. 2 when it is expressed on a complex plane.

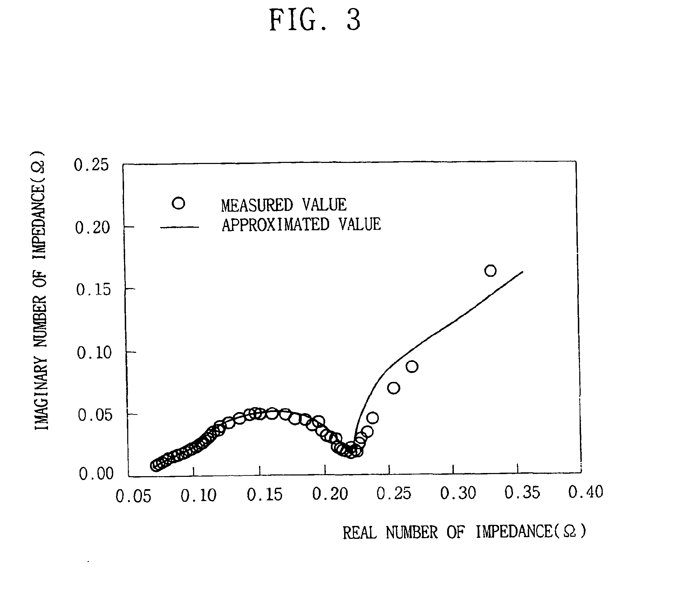

For the typical impedance spectrum (circular part of data) of lithium ion battery shown in FIG. 3. the semicircular spectrum is distorted into the oval form and has an inclination of 45 degrees in the mid-frequency band.

This phenomenon is characteristic of a battery employing porous electrodes and can be modeled with an equivalent circuit consisting of transmission line as described by E. Barsoukov, J. Hyun Kim. J. llun Kim. CO. Yoon, H. Lee. J. Electrochem. Soc. (145 (1998) 2711).

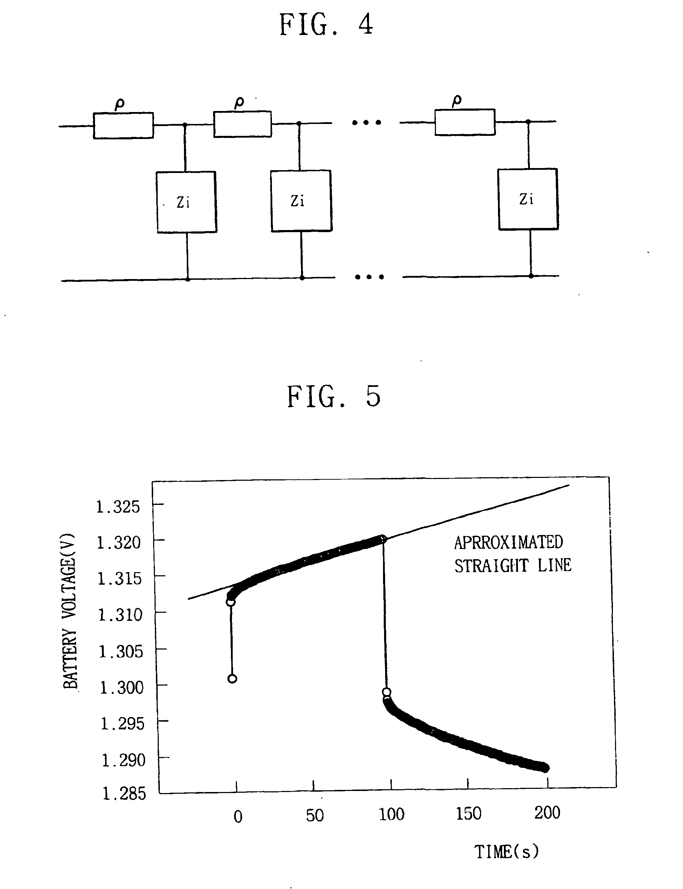

As shown in FIG.4, the transmission Hue model consists of specific resistance of electrode active material $\rho$ and interfacial impedance Zi of electrode in FIG.1a which are equivalent to distributed serial resistance and distributed parallel impedance in the form of transmission line as usual in electronics.

In the transmission line model, the de approximation $R_r$ to which the specific resistance of electrode active material contributes and prescribed pseudocapacitance $C_{ps}$ can be model parameters having correlation with battery capacity. The parameters of characteristic impedance function obtained from the solution of differential equation of equivalent circuit can be calculated from the measured impedance spectrum by the complex nonlinear least square fitting method.

The complex nonlincar least square fit of lithium ion battery obtained by using the transmission line model is represented by the solid line in FIG. 3.

Thus the fit of impedance spectra provides information concerning the model parameters.

For a certain battery, model parameters having a relation with battery capacity are primarily determined by the impedance characteristic at a low frequency.

In this case. methods in this invention can be simplified to obtain model parameters directly from time domain response.

Generally, response characteristic E(t) of a linear circuit as a function of an input signal I(t) in a given time interval is obtained from a inverse Laplace transform with respect to a product of a transfer function H(s) and the Laplace transform I(s) of the input signal, as expressed by Equation 4:

$$[\text{Equation 4}]$$

$$E(t) = \mathcal{L}^{-1}\{H(s)I(s)\}$$

For a step-wise current input signal varying from 0 to $I_o$ in current intensity when t = 0. the Laptace transform is given by

$$I(s) = \frac{I_0}{s}$$

. and the transfer function H(s) is expressed by impedance function Z(s).

If $C_{dl} \ll C_{ps}$. the impedance function of an equivalent circuit shown in FIG. 1a can be approximated by Equation 5, which determines the impedance function given by the equivalent circuit of FIG. 1b.

[Equation 5]

$$Z(s) = R_{ser} + \frac{1}{sC_{ps}} - \frac{1}{1/R_{ct} - 1/sC_{ct}}$$

On the other hand, the inverse Laplace transform in Equation 4 is defined by the Bromwich integral equation expressed by:

[Equation 6]

$$f(t) = \frac{1}{2\pi i} \int_{\gamma-i\infty}^{\gamma+i\infty} F(s) e^{st} ds$$

The inverse Laplace transform of the integrated function in Equation 6 is realized simply with reference to the Laplace transform table of an analytical function. or through a numerical analysis (see. T. Hosono. 'Fast Inversion of Laplace Transform in BASIC'. Kyoritsu Shupan. Tokyo (1984)).

When $C_{dl} \ll C_{ps}$. the response characteristic of the equivalent circuit shown in FIG. la can be calculated by Equation 7 which is rewritten from Equations 5 and 6.

[Equation 7]

$$E(t) = I_0 R_{ser} + I_0 R_{ct} + \frac{I_0}{C_{ps}} t - I_0 R_{ct} \exp(-\frac{t}{C_{dl} R_{ct}})$$

The response voltage characteristic based on a pulse current is expressed by a function having model parameters constituting an equivalent circuit according to Equation 7. Actually, the model parameters can be calculated by fitting the measured response characteristic to the function by way of linear regression or nonlinear least square fitting method.

On the other hand. in a sufficient long time interval (where, time $t \gg C_{dl}R_{ct}$). the equivalent circuit expressed by Equation 5 can be approximated to the simpler form as shown in FIG. 1c.
This results in a linear response curve plotting the voltage against the current pulse as shown in FIG. 5.

Here,

$$R_{Lim} = R_{ser} + R_{ct} \text{ and } C_{Lim} = C_{ps}$$

The current to be applied to the battery must be in a range of intensity such that the internal resistance causes a voltage drop not larger than 200mV, preferably not larger than 50mV.

Preferably, the intensity of the excitation signal is less than the signal required to fully discharge the battery in 1 hour, based on a rated battery capacity.

The pulse has to be selected to have a length that the voltage signal can be approximated to have linearity.

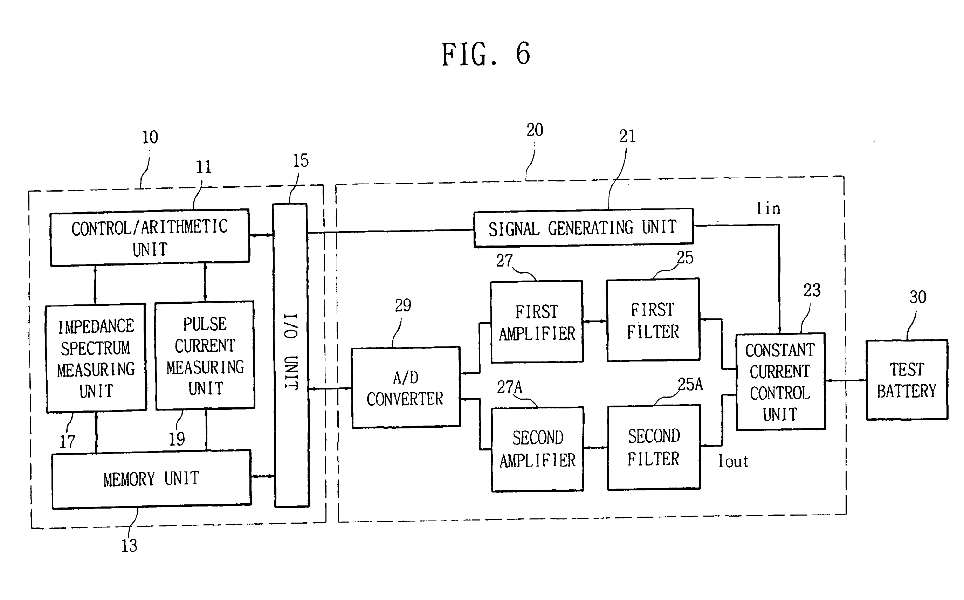

FIG. 6 is a block diagram of a unit for measuring battery capacity by applying to a test battery a perturbation current signal generated by superposition of non-overlapping multiple frequencies or a defined pulse current and measuring the current and voltage response signals of the battery based on the applied perturbation current signal or defined pulse current.

Here, reference number 10 is a control means for controlling to apply to a test battery the perturbation current signal generated by superposition of non overlapping multiple frequencies or the defined pulse current, and measuring the capacity of the test battery 30 by inputting the current and voltage response signals of the test battery 30 based on the applied perturbation current signal and defined pulse current.

The control means 10 includes: a control/arithmetic unit 11 for controlling the apply of the perturbation current signal generated by superposition of non-overlapping multiple frequencies or a defined pulse current to a test battery 30 and controlling the measurement of the capacity of test battery 30 with the current and voltage response signals of the test battery 30 according to the applied perturbation current signal and defined pulse current: a memory 13 for storing and outputting the current and voltage response signals of the test battery 30 inputted; an input/output(I/O) unit 15 for outputting the perturbation current signul of the control/arithmetic unit 11 or the apply control command of the defined pulse current, and inputting the measured current and voltage response signals of the test battery 30, and thereby applying them to the memory 13; an impedance spectrum measuring means 17 for Fourier-transforming the current and voltage response signals of the test battery 30 stored in the memory 13 according to the control of the control/arithmetic unit 11 and approximating to a value of characteristic factor; and a pulse current measuring means 19 for approximating the current and voltage response signals of the test battery 30 stored in the memory 13 to a value of characteristic factor according to the control of the control/arithmetic unit 11.

Reference number 20 denotes a measuring means for applying to the test battery the perturbation current signal generated by superposition of non-overlapping multiple frequencies or a defined pulse current according to the control of the control means 10. and measuring the current and voltage response signals of the test battery based on the applied perturbation current signal and defined pulse current, thus inputting them to the control means 10.

The measuring means 20 includes: a signal generating unit 21 for generating a perturbation current signal generated by superposition of non-overlapping multiple frequencies or a defined pulse current according to the control of the control means 10 on order to apply them to the test battery 30: a constant current control unit 23 for applying the perturbation current signal and the defined pulse current output from the signal generating unit 21 to the test battery 30, and defined pulse current and outputting voltage rcsponsc signal $V_{out}$ and current response signal $I_{out}$ of the test battery 30 based on the applied perturbation current signal and the defined pulse current: first and second filters 25 and 25A for filtering each of the voltage response signal $V_{out}$ and current response signal $I_{out}$ output from the constant current control unit 23 and removing noise out of them; first and second amplifiers 27 and 27A for amplifying the output signal of the first and second filters 25 and 25A; and a two-channel analog/digital(A/D) converter 29 for convening an output signal of the first and second amplifiers 27 and 27A into digital signal and inputting it to the control means 10.

The measuring means 20 has multi-channels. Therefore, a plurality of measuring means are connected to one control means 10. thereby individually measuring the capacity of the test battery 30 simultaneously.

In the thus-structured measuring means, when the measuring method is selected and a capacity is measured by connecting the measuring means to the test battery 30. the control/arithmetic means 11 of the control means 10 generates a control command, which is then input to a signal generating unit 21 of the measuring means 20 through the input/output unit 15.

The signal generating unit 21 stores/outputs a perturbation current signal $I_{in}$ made by superposition of non-overlapping multiple frequency in case it measures an impedance of the test battery 30 by generating an input current signal $I_m$ supposed to be input to the test battery 30 according to the control command, and stores/outputs a pulse current signal $I_m$ with a defined length and size in case of measuring in a pulse current measuring method.

According to the current signal $I_{in}$ output from the signal generating unit 21, the constant current control unit 23 generates constant current, followed by applying it to the test battery 30 and outputs a voltage response signal $V_{out}$ and a current response signal $I_{out}$ of the test battery 30 based on the constant current of the input current signal $I_{in}$ applied.

The voltage and current response signals $V_{out}$ and $I_{out}$ output from the constant current control unit 23 are filtered in the first and second filters 25 and 25A individually in order to remove noise. amplified in the first and second amplifiers 27 and 27A. and converted into the digital signal in the analog/digital(A/D) converter 29.

The digital signal from the analog/digital(A/D) converter 29 is input to the input/output unit(I/O) 15 of the control means 10 and stored in the memory 13.

Here, if the capacity of the test battery 30 is measured in the pulse current measuring method. the current response signal $I_{out}$ is not used, and there is no need to convert it into the digital signal.

In this state, the control means 10 approximates the measuring result stored in the memory 13, namely, the voltage and current response signals $V_{out}$ and $I_{out}$ to the value of the characteristic factor.

For example. in case of an impedance spectrum measurement, the impedance spectrum measuring means 17 Fourier-transforms the digital signal of the voltage and current response signals $V_{out}$ and $I_{out}$ stored in the memory 13, namely, the impedance spectrum into a complex impedance value denoted by function of frequency, and then approximates the complex impedance value to a value of the characteristic factor predefined according to the function fitting algorithm. And in case of using the pulse current measuring method. the pulse current measuring means 19 fits the voltage response signal $V_{out}$ into the value of characteristic factor pre-defined according to the response voltage function fitting algorithm.

If fitted into the predefined value of characteristic factor, is firstly examined the correlation between the value of the fitted characteristic factor and the capacity of battery measured in the real-time discharge method, and then determines the capacity of battery from the measured parameters characteristic factor of the battery of a unknown capacity based on the correlation.

Here, when simultaneously measuring a pluraliy of test batteries 30 in a multichannel method, the control means 10 performs a successive calculation corresponding to the function fitting or a nonlinear fitting into the response voltage function, and the calculation arithmetical time, however, can be ignored in comparison to the time for measuring the input and output signal.

Further, it is possible to realize a very effective apparatus for measuring and grading battery capacity by incorporating the standard battery products with a measurement unit of the present invention and a general charge/ discharge equipment for controlling the charge/discharge condition in real time.

Embodiment I (Comparative Example)

A Fourier transform impedance spectrometer is manufactured which is designed to apply an input current signal having superposition of multiple sine waves obtained by superposing odd-numbered times of the lowest frequency to a battery via a 16-bit D/A converter and a galvanostat, and transfer digital current and voltage signals measured by a two-channel 16-bit A/D converter to a computer for calculating a complex impedance by use of the digital discrete Fast Fourier transform algorithm. Herein, the pulse current measurement unit is used by storing the pulse input signal to a 16-bit A/D converter.

Table 1 lists the required times in different measurements of the capacity of a charged battery. In this embodiment, there arc used a real-time discharging method: a frequency scanning method which is performed by the number of selected frequencies at constant intervals in the range of 5 mHz to 20 kHz. e.g., 20, 40 and 60 frequencies: an impedance spectrum measuring method using a minimum sine wave of 5 mHz frequency: and a pulse current measuring method with a pulse signal.

**Table 1 :** Comparison of required times in measurement of the battery capacity.

| A | B | C | D | Ref. |
|---|---|---|---|---|
| > 1 hour | 363 sec | 200 sec | 100 sec | 20 |
| | 620 sec | | | 40 |
| | 880 sec | | | 60 |
| Note. A : real-time discharging method<br>B : frequency scanning method<br>C : impedance spectrum measuring method<br>D : pulse current measuring method | | | | |

As shown in Table 1, a use of the impedance spectrum measuring method and pulse current measuring method of the remaining capacity of a battery provide a reduction in the required time than the frequency seanning method.

Embodiment 2

A lithium ion battery (manufactured by Sony Co.) with regulated capacity of 1300 mAh is charged up to 4.2 volts under condition of constant current for one hour at room temperature and fully charged at the voltaye for 2.5 hours under condition of constant voltage. Then use is made of a Fourier transform impedance meter as described in embodiment 1 in measuring the impedance spectrum in the frequency range from 5 mHz to 20 kHz.

To obtain the impedance spectrum of the same battery in different discharge states, the battery is repeatedly discharged by 130 mAh under condition of constant current for 10 hours and the impedance spectra are measured successively.

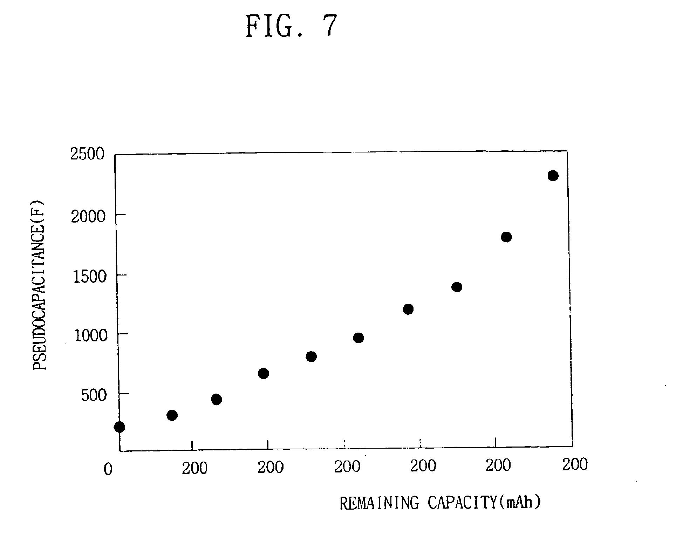

The impedance spectra are fitted by the complex nonlinear least square fitting method for the impedance function corresponding to the transmission line equivalent circuit model shown in FIG. 4 to calculate a model parameter, pseudocapacitance $C_{ps}$. A comparison of the model parameter and remaining capacity in each discharge state measured by the real-time discharge method at constant current for 5 hours reveals that there is a close correlation between the model parameter and the remaining capacity, as shown in FIG. 7.

The time required for measuring the impedance spectrum in each discharge state and calculating the model parameter by fitting did not exceed 420 seconds.

Embodiment 3

Lithium ion batteries with nominal capacity of 1300 mAh with unknown user history are fully charged in the same manner as embodiment 2. Then impedance spectrum is measured to calculate a model parameter, charge transfer resistance $R_{ct}$.

These batteries are discharged down to the final voltage of 2.7 V at a constant current of five-hour rate at room temperature and the discharge capacity of each battery is calculated. A comparison of the discharge capacity shows a correlation between the model parameter and the discharge capacity, as illustrated in FIG. S.

The time required for measuring the impedance spectrum for each battery and calculating the model parameter by approximation did not exceed 420 seconds.

Embodiment 4 (Comparative Example)

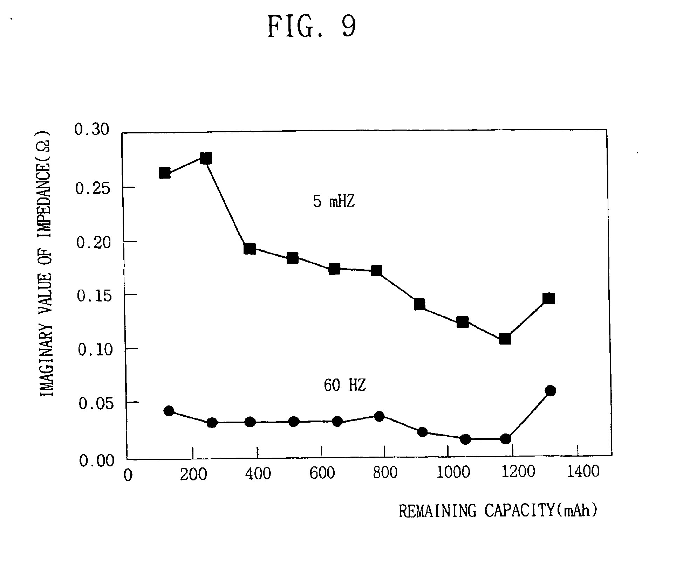

A comparison of the remaining capacity of battery and impedance at specified frequencies (5 mHz, 60 Hz) instead of model parameter for the impedance spectrum measured in embodiment 2 reveals that there is no close correlation between the impedance at each frequency and the remaining capacity, as shown in FIG.9.

Embodiment 5 (Comparative Example)

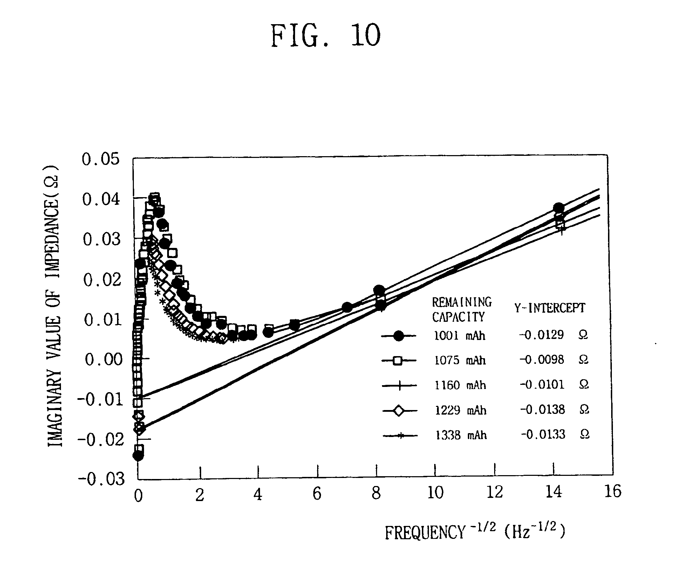

To compare the remaining capacity of battery and the numerical value derived from the frequency dependence of real or imaginary part of the internal impedance of battery, obtained or extrapolated from relatively narrow frequency range, instead of calculating model parameters for the impedance spectrum measured in embodiment 2. the relationship is examined between the imaginary value of impedance in the lower frequency region and the square root of the frequency. As a result, no close correlation is found between the absolute value and the remaining capacity, as illustrated in FIG. 10.

Embodiment 6

At a six-hour charge rate under constant current and room temperature condition, a nickel metal hydride bauery (manufactured by Emmerich) having a nominal capacity of 600 mAh is and discharge and stabilized for about 10 minutes. During an application of +30 mA current (charging current) and -30 mA current (discharging current) each for 100 seconds to the nickel metal hydride battery, the voltage is measured as a function of time.

The intensity of the current pulse. 30 mA is determined in the range that maintains the linearity of the voltage response.

Low-frequency limiting resistance $R_{Lim}$, and low-frequency limiting capacitance $C_{Lim}$ which are model parameters of the equivalent circuit of FIG. I a are calculated from the slope and y-intercept of the linear line obtained through a linear regression from the voltage response characteristic based on charge current.

In order to obtain the pulse current response characteristic in another discharge condition of the same battery, the nickel metal hydride battery is discharged each time by 30 mAh at a 60 mA constant current condition and repeatedty measured in regards 5 to the pulse current in an analogous manner as described above. Subsequently, model parameters such as low-frequency limiting resistance $R_{Lim}$, and low-frequency limiting capacitance $C_{Lim}$ are calculated.

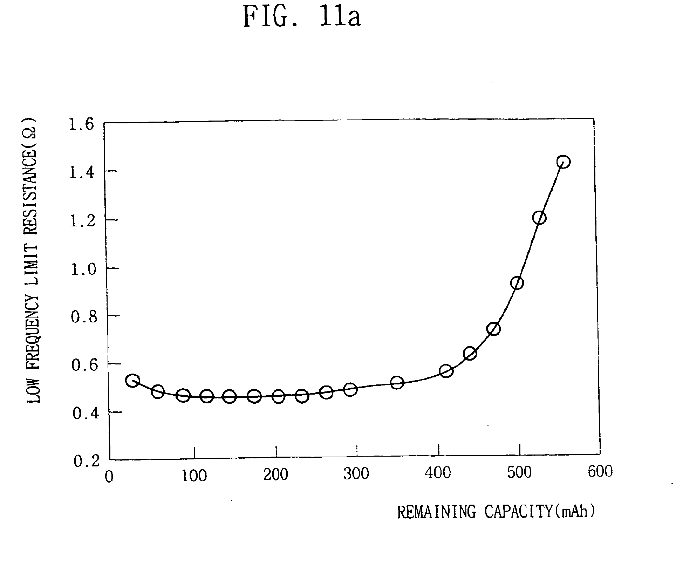

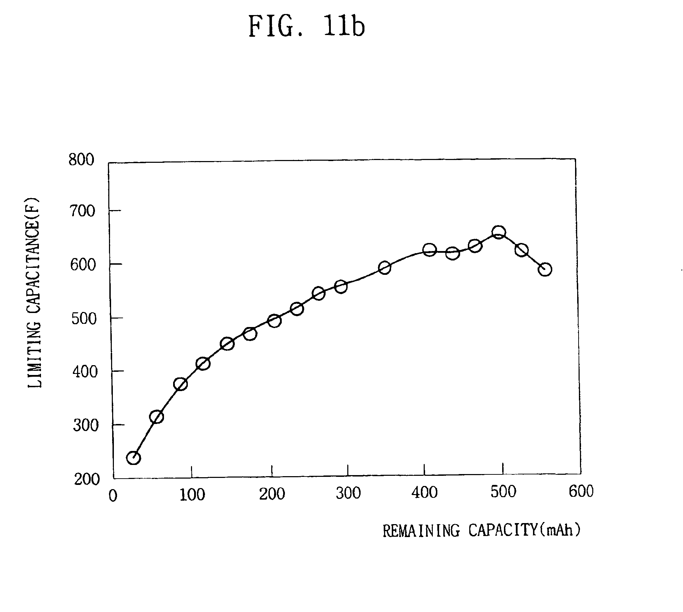

As apparent from table I and FIGS. 11a and 11b, a comparison of the remaining capacities of the battery which are measured in each discharge condition by a real-time discharge method at a 60 mA constant current condition reveals that there is a close correlation between the remaining capacity and the model parameters, i.e.. low-frequency limiting capacitance and low-frequency limiting resistance.

Embodiment 7

A lithium ion battery (manufactured by Sony) having a nominal capacity of 1300 mAh is charged to 4.2 volts at the 1-hour rate in a constant current for one hour and room temperature condition. and stabilized for 2.5 hours under a 4.2 V constant voltage condition. Atier this. a voltage response curve of the battery is obtained after performing the same current pulse measurement unit as described in embodiment 6.

In order to obtain a response curve of the identical battery in another discharge state. the batterv is discharged each time by 60 mAh in a 120 mA constant current condition and repeatedly measured in regards to the pulse current.

The used pulse current is +100 mA in intensity and has a time width of 400 seconds.

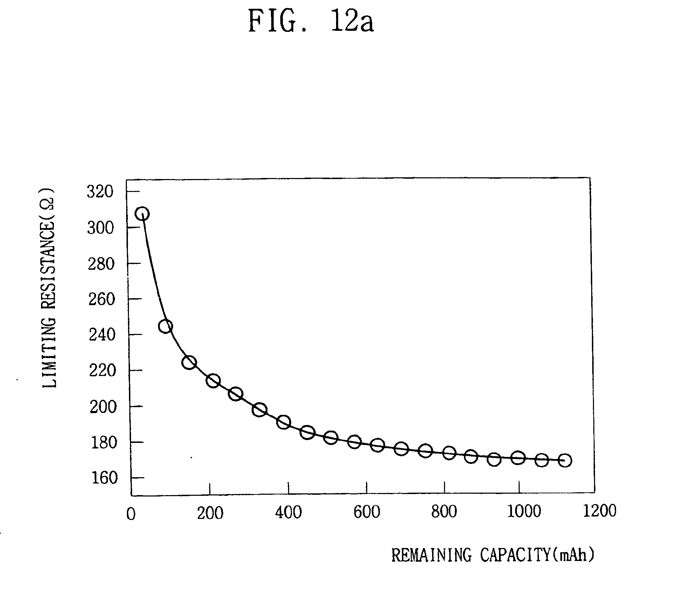

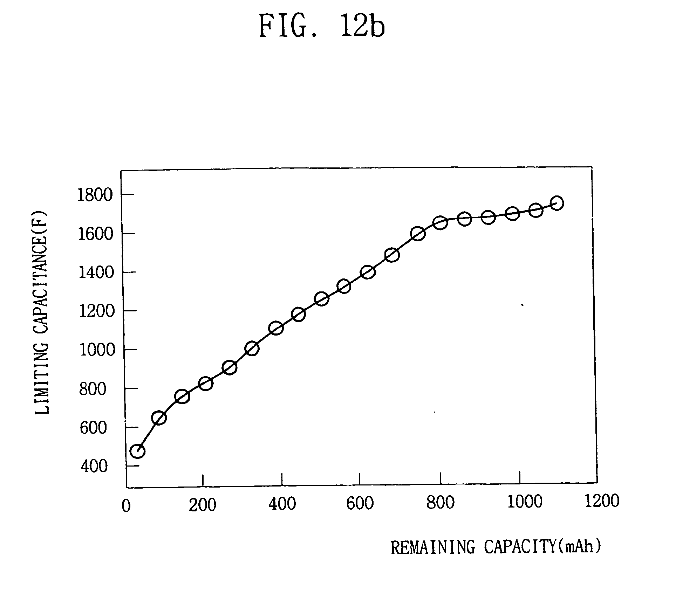

For each voltage response curve, model parameters such as low-frequency limitiny resistance $R_{lim}$, and low-frequency limiting capacitance $C_{Lim}$ are calculated through a linear regression of an impedance function corresponding to the equivalent circuit of FIG. 1c. As shown in FIGS. 12a and 12b. a comparison of the remaining capacities of the battery which are measured in each discharge condition by a real-time discharge method using a constant current of 120 mA reveals that there is a close correlation between the remaining capacity and the model parameters. i.e.. low-frequency limiting capacitance and low-frequency limiting resistance.

The time required to measure the voltage response curve and obtain model parameters through a fitting in each discharge condition did not exceed 200 seconds.

Embodiment 8

Six lithium ion batteries (manufactured by Sanyo) each of which has a nominal capacity of 1300 mAh and unknown history are charged, and a voltage response curve of each battery is obtained with the current pulse used in embodiment 7.

Model parameters are calculated by the non-linear least square fitting method according to Equation 7.

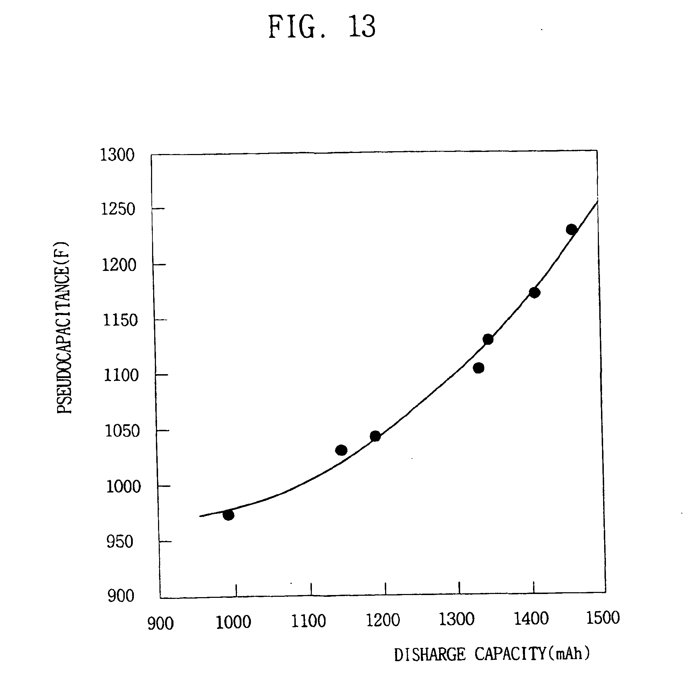

The batteries are discharged to a 2.7 volts at the 5-hour rate in a constant current and room temperature condition, and the discharge capacity of each battery for a measured discharge period is calculated. As apparent from table 2 and FIG. 13, there is a close correlation between the remaining capacity and the model parameters, i.e., low-frequency limiting capacitance $C_{dl}$ and low-frequency limiting resistance $C_{ps}$.

The time required to measure the voltage response curve and obtain model parameters through an approximation did not exceed 200 seconds.

Table 2 : Results of an analysis for the electrical capacity and the response signals based on the pulse current of each lithium ion battery obtained through a real-time discharge method.

| CAPACITY (mAh) | $R_{ct}$ (Ω) | $C_{dl}$ (Farad) | $C_{ps}$ (Farad) |
|---|---|---|---|
| 1463 | 0.1939 | 14.67 | 1230.9 |
| 1409 | 0.1830 | 19.01 | 1174.9 |
| 1331 | 0.2352 | 25.89 | 1105.8 |
| 1189 | 0.2848 | 26.27 | 1045.8 |

| | | | |
|---|---|---|---|
| 1145 | 0.4595 | 28.52 | 1032.8 |
| 992 | 0.4619 | 28.60 | 973.1 |

## Industrial Application

Such as in the present invention described above, there is provided with a measurement of a unknown battery capacity by measuring parameters obtained from voltage response signal of a current waveform or impedance spectrum generated thereof, is more excellent in efficiency and accuracy than the related art measurement for battery capacity. Such a measurement can be used for the user to measure the capacity of primary and secondary batteries used for portable electronics, power tools, communication equipment, automobiles and electric vehicles, or to measure or grade the battery capacity in production of the primary and secondary batteries on a large scale.

It will be apparent to those skilled in the art that various modifications and variations can be made in the present invention without departing from the scope of the invention. Thus, it is intended that the present invention cover the modifications and variations of this invention provided they come within the scope of the appended claims.

## Claims

1. A method for measuring battery capacity, **characterised in that** the method comprises the steps of:

   (1) measuring, as a function of time, a voltage or current response signal resulting from the application of a current or voltage excitation signal to both ends of a battery;
   (2) analyzing the measured response signal to determine a parameter or parameters of a predefined impedance model of the battery;
   (3) examining a correlation between the parameter or parameters and the capacity of the battery measured by a real-time discharge method; and
   (4) based on the correlation, determining the capacity of the battery from the parameter or parameters.

2. The method as defined in claim 1, wherein the intensity of the excitation signal is less than the signal required to fully discharge the battery in 1 hour, based on a rated battery capacity.

3. The method as defined in claim 1, wherein a time required to measure the voltage characteristic in response to the excitation signal is below 1/10 of the full discharge time at a given current or voltage calculated from a rated battery capacity.

4. The method as defined in claim 1, wherein the applied signal is a current or voltage pulse.

5. The method as defined in claim 1 or 4, wherein the parameter or parameters are model parameters determined from fitting the measured response signal to a time domain response function obtained from an equivalent circuit comprising resistors, capacitors or transmission lines.

6. The method as defined in claim 4, wherein the step of analyzing the measured response signal comprises fitting the measured response signal to a response function obtained by taking an inverse Laplace's transform of the impedance function of the battery model multiplied by a current pulse function expressed in the Laplace domain or divided by a voltage pulse function expressed in the Laplace domain.

7. The method as claimed in claim 1, further comprising the step of:

    converting the measured response signal into the complex impedance spectrum of the battery model in a predetermined frequency region before the step of analyzing;
    wherein the step of analyzing comprises determining one or more parameters from the measured complex impedance spectrum.

8. The method as claimed in claim 7, wherein the ratio of the highest and lowest frequencies in the predetermined frequency region is at least 100.

9. The method as claimed in claim 7, wherein the one or more parameters are model parameters determined by fitting the measured complex impedance spectrum of the battery model to a complex impedance function of an equivalent circuit comprising resistors, capacitors and transmission lines.

10. The method as claimed in claim 7, wherein the excitation signal is applied to both terminals of the battery under galvanostatic conditions.

11. The method as claimed in claim 7, wherein the time that the current excitation is applied to the battery to measure the complex impedance spectrum is within 1 hour.

12. The method as claimed in claim 7, wherein the parameters are model parameters determined using a complex nonlinear least square fitting of impedance data to a complex impedance function of a model circuit comprising resistors, capacitors or transmission lines.

13. The method as claimed in claim 7, wherein the applied excitation signal is a combination of non-overlapping sine-waves having selected frequencies, and wherein the excitation signal can be transformed into the frequency domain so that the ratio between the amplitude of a wave at a selected frequency to the amplitude of a wave at another frequency is more than 100.

14. The method as claimed in claim 7, wherein a fast Fourier transform is used to obtain a complex impedance spectrum from the measured response signal.

15. The method as claimed in claim 7, wherein the excitation signal is a current or voltage pulse, and a Laplace transform is used to obtain a complex impedance spectrum from the measured response signal.

16. An apparatus for measuring capacity of a battery (30), **characterised in that** the apparatus comprises:

    control means (10) adapted to:

        (a) generate either (i) an excitation signal comprising a combination of non-overlapping sine waves with selected frequencies, or (ii) a pulse signal;

(b) transfer the generated signal as a control signal to measuring means (20) which is adapted to apply it to the battery;

(c) receive time-varying current and voltage response signals detected by the measuring means (20);

(d) analyze the time-varying current and voltage response signals to obtain a parameter or parameters of a predefined impedance model of the battery (30);

(e) correlate the parameter or parameters and the capacity of the battery (30) measured by a real-time discharge method; and

(f) determine the capacity of the battery (30) based on the correlation; measuring means (20) adapted to:

  (a) apply the generated excitation signal or pulse signal to the test battery (30);
  (b) detect the time-varying current and voltage response signals of the test battery (30); and
  (c) transmit the response signal to the control means (10).

**17.** The apparatus as defined in claim 16, wherein the control means (10) comprises:

  a control/arithmetic unit (11) for controlling the application of the excitation signal or pulse signal to the test battery (30), and controlling the measurement of the capacity of the test battery (30) using the time-varying current and voltage response signals of the test battery (30);
  a memory (13) for storing and outputting the time-varying current and voltage response signals of the test battery (30) received from the measuring means (20);
  an input/output unit (15) for outputting the excitation signal of the control/arithmetic unit (11) or a control command for the defined pulse signal to the measuring means (20), and receiving the time-warying current and voltage response signals measured on the test battery (30), and outputting the time-varying current and voltage response signals to the memory (13);
  a model parameter measuring means (17) for fitting the stored time-varying current and voltage response signals of the test battery (30) to a time-domain function of a model circuit to determine the values of the parameter or parameters.

**18.** The apparatus as defined in claim 16, wherein the control means (10) comprises:

  a control/arithmetic unit (11) for controlling the application of the excitation signal or pulse signal to the test battery (30), and controlling the measurement of the capacity of the test battery (30) using the time-varying current and voltage response signals of the test battery (30);
  a memory (13) for storing and outputting the time-varying current and voltage response signals of the test battery (30) received from the measuring means (20);
  an input/output unit (15) for outputting the excitation signal of the control/arithmetic unit (11) or a control command for the defined pulse signal to the measuring means (20), and receiving the time-varying current and voltage response signals measured on the test battery (30), and outputting the time-varying current and voltage response signals to the memory (13);
  a model parameter measuring means (17) including at complex impedance spectrum measuring means for Fourier-transforming the stored time-varying current and voltage response signals of the test battery (30) and fitting the obtained complex impedance spectrum to a complex impedance function of the battery model to determine the values of the parameter or parameters.

**19.** The apparatus as defined in claim 16, wherein the apparatus further comprises a plurality of measuring means (20) each connected to a respective battery (30) through multi-channels, each being adapted to receive the excitation signal or the defined pulse signal and individually detect the time-varying voltage and current response signals based on the applied excitation signal and input them to the control means (10).

**20.** The apparatus as defined in claim 16, 17 or 18, wherein the measuring means (20) comprises:

  a signal generating unit (21) for storing a pre-defined excitation signal and defined pulse signal and outputting the excitation signal and the defined pulse signal selected by the control means (10);
  a constant current control unit (23) for applying an output current of the signal generating unit (21) to the battery (30) and detecting the time-varying current and voltage response signals based on the current applied; and
  an analog/digital converter (29) for successively converting the time-varying current and voltage response signals detected by the constant current control unit (23) into digital signals and inputting them to the control means (10).

**21.** The apparatus as defined in claim 20, further comprising:

first and second filters (25,25A) for respectively filtering the time-varying current and voltage response signals detected by the constant current control unit (23) to remove noise; and
first and second amplifiers (27,27A) for amplifying the output signal of the first and second filters (25,25A) and inputting them to the analog/digital converter (29).

**Patentansprüche**

**1.** Verfahren zum Messen der Batteriekapazität, **dadurch gekennzeichnet, dass** das Verfahren die folgenden Schritte umfasst:

(1) Messen eines Spannungs- oder Stromantwortsignals als Funktion der Zeit, das aus dem Anlegen eines Strom- oder Spannungsanregungssignals an beide Anschlüsse einer Batterie resultiert,
(2) Analyse des gemessenen Antwortsignals zum Bestimmen eines Parameters oder von Parametern eines vorgegebenen Impedanzmodells der Batterie,
(3) Untersuchung der Korrelation zwischen dem Parameter oder den Parametern und der Kapazität der Batterie, die mit einem Echtzeitentladungsverfahren gemessen wird, und
(4) Bestimmen der Kapazität der Batterie aus dem Parameter oder den Parametern auf der Basis der Korrelation.

**2.** Verfahren nach Anspruch 1, wobei die Intensität des Anregungssignals kleiner als die des Signals ist, das zum völligen Entladen der Batterie in 1 Stunde auf der Grundlage einer Batterienennkapazität erforderlich ist.

**3.** Verfahren nach Anspruch 1, wobei eine Zeit, die zum Messen der Spannungskennlinie als Reaktion auf das Anregungssignal benötigt wird, kleiner als 1/10 der vollen Entladungszeit bei einem gegebenen Strom oder einer gegebenen Spannung, die aus einer Batterienennkapazität berechnet wird, ist.

**4.** Verfahren nach Anspruch 1, wobei das angelegte Signal ein Strom- oder Spannungsimpuls ist.

**5.** Verfahren nach Anspruch 1 oder 4, wobei der Parameter oder die Parameter Modellparameter sind, die aus der Anpassung des gemessenen Antwortsignals an eine Zeitbereichsantwortfunktion, die aus einem äquivalenten Stromkreis, der Widerstände, Kondensatoren oder Übertragungsleitungen umfasst, erhalten wird, bestimmt wird.

**6.** Verfahren nach Anspruch 4, wobei der Schritt des Analysierens des gemessenen Antwortsignals das Anpassen des gemessenen Antwortsignals an eine Antwortfunktion, die durch Verwenden einer inversen Laplace-Transformation der Impedanzfunktion des Batteriemodells, multipliziert mit einer Stromimpulsfunktion, die im Laplace-Bereich ausgedrückt wird, oder dividiert durch eine Spannungsimpulsfunktion, die im Laplace-Bereich ausgedrückt wird, umfasst.

**7.** Verfahren nach Anspruch 1, weiterhin den Schritt umfassend:

Umwandlung des gemessenen Antwortsignals in das komplexe Impedanzspektrum des Batteriemodells in einem vorgegebenen Frequenzbereich vor dem Schritt des Analysierens,
wobei der Schritt des Analysierens das Bestimmen von einem oder mehr Parametern aus dem gemessenen komplexen Impedanzspektrum umfasst.

**8.** Verfahren nach Anspruch 7, wobei das Verhältnis der höchsten zur niedrigsten Frequenz im vorgegebenen Frequenzbereich mindestens 100 beträgt.

**9.** Verfahren nach Anspruch 7, wobei der eine oder die mehreren Parameter Modellparameter sind, die durch Anpassen des gemessenen komplexen Impedanzspektrums des Batteriemodells an eine komplexe Impedanzfunktion eines äquivalenten Stromkreises, der Widerstände, Kondensatoren oder Übertragungsleitungen umfasst, bestimmt werden.

**10.** Verfahren nach Anspruch 7, wobei das Anregungssignal an beide Klemmen der Batterie unter galvanostatischen Bedingungen angelegt wird.

**11.** Verfahren nach Anspruch 7, wobei die Zeitdauer, während der die Stromanregung an die Batterie zum Messen des komplexen Impedanzspektrums angelegt wird, nicht mehr als 1 Stunde beträgt.

**12.** Verfahren nach Anspruch 7, wobei die Parameter Modellparameters sind, die unter Verwendung eines komplexen nichtlinearen Verfahrens der kleinsten Quadrate zum Anpassen der Impedanzdaten an eine komplexe Impedanzfunktion eines Modellstromkreises, der Widerstände, Kondensatoren oder Übertragungsleitungen umfasst, bestimmt werden.

**13.** Verfahren nach Anspruch 7, wobei das angelegte Anregungssignal eine Kombination von nichtüberlappenden Sinuswellen ist, die ausgewählte Frequenzen haben, und wobei das Anregungssignal in den Frequenzbereich transformiert werden kann, so dass das Verhältnis zwischen der Amplitude einer Welle bei einer ausgewählten Frequenz zur Amplitude einer Welle bei einer weiteren Frequenz mehr als 100 beträgt.

**14.** Verfahren nach Anspruch 7, wobei eine schnelle Fourier-Transformation verwendet wird, um ein komplexes Impedanzspektrum aus dem gemessenen Antwortsignal zu erhalten.

**15.** Verfahren nach Anspruch 7, wobei das Anregungssignal ein Strom- oder Spannungsimpuls ist und wobei eine Laplace-Transformation verwendet wird, um ein komplexes Impedanzspektrum aus dem gemessenen Antwortsignal zu erhalten.

**16.** Vorrichtung zum Messen der Kapazität einer Batterie (30), **dadurch gekennzeichnet, dass** die Vorrichtung umfasst:

Kontrollmittel (10), das ausgelegt ist zum:

(a) Erzeugen entweder (I) eines Anregungssignals, das eine Kombination von nichtüberlappenden Sinuswellen bei ausgewählten Frequenzen umfasst, oder (II) eines Impulssignals,
(b) Übertragen des erzeugten Signals als Kontrollsignal an ein Messmittel (20), welches zum Anlegen des Signals an die Batterie ausgelegt ist,
(c) Empfangen von zeitvariablen Strom- und Spannungsantwortsignalen, die durch das Messmittel (20) festgestellt werden,
(d) Analysieren der zeitvariablen Strom- und Spannungsantwortsignale, um einen Parameter oder um Parameter des vorgegebenen Impedanzmodells der Batterie (30) zu erhalten,
(e) Korrelieren des Parameters oder der Parameter und der Kapazität der Batterie (30), die durch ein Echtzeitentladungsverfahren gemessen wurde, und
(f) Bestimmen der Kapazität der Batterie (30) auf der Grundlage der Korrelation;

Messmittel (20), das ausgelegt ist zum:

(a) Anlegen des erzeugten Anregungssignals oder Impulssignals an die Testbatterie (30)
(b) Feststellen der zeitvariablen Strom- und Spannungsantwortsignale der Testbatterie (30), und
(c) Übertragen des Antwortsignals an das Kontrollmittel (10).

**17.** Vorrichtung nach Anspruch 16, wobei das Kontrollmittel (10) umfasst:

ein Steuer-/Rechenwerk (11) zum Steuern des Anlegens des Anregungssignals oder Impulssignals an die Testbatterie (30) und zum Steuern der Messung der Kapazität der Testbatterie (30) unter Verwendung der zeitvariablen Strom- und Spannungsantwortsignale der Testbatterie (30),
einen Speicher (13) zur Speicherung und Ausgabe der zeitvariablen Strom- und Spannungsantwortsignale der Testbatterie (30), die vom Messmittel (20) erhalten wurden,
eine Ein-/Ausgabeeinheit (15) zum Ausgeben des Anregungssignals des Steuer-/Rechenwerks (11) oder eines Steuerbefehls für das festgelegte Impulssignal an das Messmittel (20) und zum Empfangen der zeitvariablen Strom- und Spannungsantwortsignale, die an der Testbatterie (30) gemessen werden, und Ausgeben der zeitvariablen Strom- und Spannungsantwortsignale an den Speicher (13),
ein Modellparametermessmittel (17) zum Anpassen der gespeicherten zeitvariablen Strom- und Spannungsantwortsignale der Testbatterie (30) an eine Zeitbereichsfunktion eines Modellstromkreises, um die Werte des Parameters oder der Parameter zu bestimmen.

**18.** Vorrichtung nach Anspruch 16, wobei das Kontrollmittel (10) umfasst:

ein Steuer-/Rechenwerk (11) zum Steuern des Anlegens des Anregungssignals oder Impulssignals an die Testbatterie (30) und zum Steuern der Messung der Kapazität der Testbatterie (30) unter Verwendung der zeitvariablen Strom- und Spannungsantwortsignale der Testbatterie (30),
einen Speicher (13) zur Speicherung und Ausgabe der zeitvariablen Strom- und Spannungsantwortsignale der Testbatterie (30), die vom Messmittel (20) erhalten wurden,
eine Ein-/Ausgabeeinheit (15) zum Ausgeben des Anregungssignals des Steuer-/Rechenwerks (11) oder eines Steuerbefehls für das festgelegte Impulssignal an das Messmittel (20) und zum Empfangen der zeitvariablen Strom- und Spannungsantwortsignale, die an der Testbatterie (30) gemessen werden, und Ausgeben der zeitvariablen Strom- und Spannungsantwortsignale an den Speicher (13),
ein Modellparametermessmittel (17) einschließlich eines komplexen Impedanzspektrumsmessmittels für die Fourier-Transformation der gespeicherten zeitvariablen Strom- und Spannungsantwortsignale der Testbatterie (30) und zum Anpassen des erhaltenen komplexen Impedanzspektrums an eine komplexe Impedanzfunktion der Batterie, um die Werte des Parameters oder der Parameter zu bestimmen.

**19.** Vorrichtung nach Anspruch 16, wobei die Vorrichtung weiterhin mehrere Messmittel (20) umfasst, die jeweils an eine entsprechende Batterie (30) über mehrere Kanäle angeschlossen sind, wobei jedes für den Empfang des Anregungssignals oder des definierten Impulssignals ausgelegt ist, und die individuell die zeitvariablen Strom- und Spannungsantwortsignale, die auf dem angelegten Anregungssignal beruhen, feststellen; und sie in das Kontrollmittel (10) eingibt.

**20.** Vorrichtung nach Anspruch 16, 17 oder 18, wobei das Messmittel (20) umfasst:

eine Signalerzeugungseinheit (21) zum Speichern eines vorgegebenen Anregungssignals und des definierten Impulssignals und zum Ausgeben des Anregungssignals und des definierten Impulssignals, das durch das Kontrollmittel (10) ausgewählt wird,
eine Konstantstromsteuereinheit (23) zum Anlegen eines Ausgangsstroms der Signalerzeugungseinheit (21) an die Batterie (30) und zum Feststellen der zeitvariablen Strom- und Spannungsantwortsignale, die auf dem angelegten Strom beruhen, und
einen Analog-Digital-Umwandler (29) zum fortlaufenden Umwandeln der zeitvariablen Strom- und Spannungsantwortsignale, welche durch die Konstantstromsteuereinheit (23) festgestellt werden, in digitale Signale und zum Eingeben dieser Signale in das Kontrollmittel (10).

**21.** Vorrichtung nach Anspruch 20, weiterhin umfassend:

erste und zweite Filter (25, 25A) zum jeweiligen Filtern der zeitvariablen Strom- und Spannungsantwortsignale, die durch die Konstantstromsteuereinheit (23) festgestellt werden, um Rauschen zu entfernen, und
erste und zweite Verstärker (27, 27A) zum Verstärken des Ausgangssignals des ersten und zweiten Filters (25, 25A) und zum Eingeben desselben in den Analog-Digital-Umwandler (29).

**Revendications**

**1.** Procédé de mesure de la capacité d'une batterie, **caractérisé en ce que** le procédé comprend les étapes consistant à :

(1) mesurer, en fonction du temps, un signal de réponse de tension ou de courant résultant de l'application d'un signal d'excitation de courant ou de tension aux deux extrémités d'une batterie ;
(2) analyser le signal de réponse mesuré pour déterminer un ou des paramètres d'un modèle d'impédance prédéfini de la batterie ;
(3) examiner une corrélation entre le ou les paramètres et la capacité de la batterie mesurée par un procédé de décharge dans le temps réel ; et
(4) sur la base de la corrélation, déterminer la capacité de la batterie à partir du ou des paramètres.

**2.** Procédé selon la revendication 1, dans lequel l'intensité du signal d'excitation est inférieure au signal requis pour décharger totalement la batterie en 1 heure, sur la base d'une capacité nominale de batterie.

**3.** Procédé selon la revendication 1, dans lequel un temps nécessaire pour mesurer la caractéristique de tension en réponse au signal d'excitation est inférieur à 1/10 du temps de décharge total à un courant ou une tension donné (e) calculé(e) à partir d'une capacité nominale de batterie.

**4.** Procédé selon la revendication 1, dans lequel le signal appliqué est une impulsion de courant ou de tension.

**5.** Procédé selon la revendication 1 ou 4, dans lequel le ou les paramètres sont des paramètres modèles déterminés à partir de l'ajustement du signal de réponse mesuré à une fonction de réponse de domaine temporel obtenue à partir d'un circuit équivalent comprenant des résistances, des condensateurs ou des lignes de transmission.

**6.** Procédé selon la revendication 4, dans lequel l'étape d'analyse du signal de réponse mesuré comprend l'ajustement du signal de réponse mesuré à une fonction de réponse obtenue en prenant une transformée de Laplace inverse de la fonction d'impédance du modèle de batterie multipliée par une fonction d'impulsion de courant exprimée dans le domaine de Laplace ou divisée par une fonction d'impulsion de tension exprimée dans le domaine de Laplace.

**7.** Procédé selon la revendication 1, comprenant en outre l'étape consistant à :

convertir le signal de réponse mesuré en spectre d'impédance complexe du modèle de batterie dans une région de fréquence prédéterminée avant l'étape d'analyse ; dans lequel l'étape d'analyse comprend le fait de déterminer un ou plusieurs paramètres à partir du spectre d'impédance complexe mesuré.

**8.** Procédé selon la revendication 7, dans lequel le rapport de la fréquence la plus élevée sur la fréquence la plus faible dans la région de fréquence prédéterminée est au moins de 100.

**9.** Procédé selon la revendication 7, dans lequel le ou les paramètres sont des paramètres modèles déterminés en mettant le spectre d'impédance complexe mesuré du modèle de batterie en correspondance avec une fonction d'impédance complexe d'un circuit équivalent comprenant des résistances, des condensateurs et des lignes de transmission.

**10.** Procédé selon la revendication 7, dans lequel le signal d'excitation est appliqué aux deux bornes de la batterie dans des conditions galvanostatiques.

**11.** Procédé selon la revendication 7, dans lequel le temps pendant lequel l'excitation de courant est appliquée à la batterie pour mesurer le spectre d'impédance complexe est de 1 heure.

**12.** Procédé selon la revendication 7, dans lequel les paramètres sont des paramètres modèles déterminés en utilisant un ajustement par les moindres carrés, complexe, non linéaire des données d'impédance à une fonction d'impédance complexe d'un circuit modèle comprenant des résistances, des condensateurs ou des lignes de transmission.

**13.** Procédé selon la revendication 7, dans lequel le signal d'excitation appliqué est une combinaison d'ondes sinusoïdales ne se chevauchant pas ayant des fréquences sélectionnées, et dans lequel le signal d'excitation peut être transformé dans le domaine de fréquence de sorte que le rapport entre l'amplitude d'une onde à une fréquence sélectionnée et l'amplitude d'une onde à une autre fréquence soit supérieur à 100.

**14.** Procédé selon la revendication 7, dans lequel une transformée de Fourier rapide est utilisée pour obtenir un spectre d'impédance complexe à partir du signal de réponse mesuré.

**15.** Procédé selon la revendication 7, dans lequel le signal d'excitation est une impulsion de courant ou de tension, et une transformée de Laplace est utilisée pour obtenir un spectre d'impédance complexe à partir du signal de réponse mesuré.

**16.** Appareil de mesure de la capacité d'une batterie (30), **caractérisé en ce que** l'appareil comprend :

un moyen de commande (10) adapté pour :

(a) générer (i) un signal d'excitation comprenant une combinaison d'ondes sinusoïdales ne se chevauchant pas avec des fréquences sélectionnées, ou (ii) un signal d'impulsion ;
(b) transférer le signal généré en tant que signal de commande vers un moyen de mesure (20) qui est adapté pour l'appliquer à la batterie ;

(c) recevoir des signaux de réponse de courant et de tension variables dans le temps détectés par le moyen de mesure (20) ;

(d) analyser les signaux de réponse de courant et de tension variables dans le temps pour obtenir un ou des paramètres d'un modèle d'impédance prédéfini de la batterie (30) ;

(e) corréler le ou les paramètres et la capacité de la batterie (30) mesurée par un procédé de décharge dans le temps réel ; et

(f) déterminer la capacité de la batterie (30) sur la base de la corrélation ;

un moyen de mesure (20) adapté pour :

(a) appliquer le signal d'excitation ou le signal d'impulsion généré à la batterie test (30) ;

(b) détecter les signaux de réponse de courant et de tension variables dans le temps de la batterie test (30) ; et

(c) transmettre le signal de réponse au moyen de commande (10).

**17.** Appareil selon la revendication 16, dans lequel le moyen de commande (10) comprend :

une unité de commande/arithmétique (11) destinée à commander l'application du signal d'excitation ou du signal d'impulsion à la batterie test (30), et à commander la mesure de la capacité de la batterie test (30) en utilisant les signaux de réponse de courant et de tension variables dans le temps de la batterie test (30) ;

une mémoire (13) destinée à stocker et à sortir les signaux de réponse de courant et de tension variables dans le temps de la batterie test (30) reçus en provenance du moyen de mesure (20) ;

une unité d'entrée/sortie (15) destinée à sortir le signal d'excitation de l'unité de commande/arithmétique (11) ou une commande pour le signal d'impulsion défini sur le moyen de mesure (20), et à recevoir les signaux de réponse de courant et de tension variables dans le temps mesurés sur la batterie test (30), et à sortir les signaux de réponse de courant et de tension variables dans le temps sur la mémoire (13) ;

un moyen de mesure de paramètre modèle (17) destiné à mettre les signaux de réponse de courant et de tension variables dans le temps de la batterie test (30) en correspondance avec une fonction du domaine temporel d'un circuit modèle pour déterminer les valeurs du ou des paramètres.

**18.** Appareil selon la revendication 16, dans lequel le moyen de commande (10) comprend :

une unité de commande/arithmétique (11) destinée à commander l'application du signal d'excitation ou du signal d'impulsion à la batterie test (30), et à commander la mesure de la capacité de la batterie test (30) en utilisant les signaux de réponse de courant et de tension variables dans le temps de la batterie test (30) ;

une mémoire (13) destinée à stocker et à sortir les signaux de réponse de courant et de tension variables dans le temps de la batterie test (30) reçus en provenance du moyen de mesure (20) ;

une unité d'entrée/sortie (15) destinée à sortir le signal d'excitation de l'unité de commande/arithmétique (11) ou une commande pour le signal d'impulsion défini sur le moyen de mesure (20), et à recevoir les signaux de réponse de courant et de tension variables dans le temps mesurés sur la batterie test (30), et à sortir les signaux de réponse de courant et de tension variables dans le temps sur la mémoire (13) ;

un moyen de mesure de paramètre modèle (17) comprenant un moyen de mesure de spectre d'impédance complexe pour effectuer une transformée de Fourier sur les signaux de réponse de courant et de tension variables dans le temps stockés de la batterie test (30) et mettant le spectre d'impédance complexe obtenu en correspondance avec une fonction d'impédance complexe du modèle de batterie pour déterminer les valeurs du ou des paramètres.

**19.** Appareil selon la revendication 16, dans lequel l'appareil comprend en outre une pluralité de moyens de mesure (20) reliés chacun à une batterie respective (30) par le biais de canaux multiples, chacun étant adapté pour recevoir le signal d'excitation ou le signal d'impulsion défini, et détecter individuellement les signaux de réponse de courant et de tension variables dans le temps sur la base du signal d'excitation appliqué ; et les entrer dans le moyen de commande (10).

**20.** Appareil selon la revendication 16, 17 ou 18, dans lequel le moyen de mesure (20) comprend :

une unité de génération de signal (21) destinée à stocker un signal d'excitation prédéfini et un signal d'impulsion défini et à sortir le signal d'excitation et le signal d'impulsion défini sélectionnés par le moyen de commande (10) ;

une unité de commande de courant constant (23) destinée à appliquer un courant de sortie de l'unité de génération de signal (21) sur la batterie (30) et à détecter les signaux de réponse de courant et de tension variables dans le temps sur la base du courant appliqué ; et

un convertisseur analogique/numérique (29) destiné à convertir avec succès les signaux de réponse de courant et de tension variables dans le temps détectés par l'unité de commande de courant constant (23) en signaux numériques et à les entrer dans le moyen de commande (10).

21. Appareil selon la revendication 20, comprenant en outre :

des premier et second filtres (25, 25A) destinés à filtrer respectivement les signaux de réponse de courant et de tension variables dans le temps détectés par l'unité de commande de courant constant (23) pour éliminer le bruit ; et

des premier et second amplificateurs (27, 27A) destinés à amplifier le signal de sortie des premier et second filtres (25, 25A) et à les entrer dans le convertisseur analogique/numérique (29).

# FIG. 1

(a)

Rser    Rct    Cps

Cdl

$$Z(s) = R_{ser} + \cfrac{1}{\cfrac{1}{R_{ct} + \cfrac{1}{sC_{ps}}} + sC_{dl}}$$

$C_{dl} \ll C_{ps}$

(b)

Rser    Rct    Cps

Cdl

$$Z(s) = R_{ser} + \cfrac{1}{\cfrac{1}{R_{ct}} + sC_{dl}} + \cfrac{1}{sC_{ps}}$$

$t \gg C_{dl}R_{ct}$

(c)

RLim    CLim

$$Z(s) = R_{Lim} + \frac{1}{sC_{Lim}}$$

# FIG. 2

# FIG. 3

FIG. 4

FIG. 5

# FIG. 6

EP 1 088 240 B1

# FIG. 7

# FIG. 8

FIG. 9

# FIG. 10

# FIG. 11a

# FIG. 11b

# FIG. 12a

REMAINING CAPACITY(mAh)

# FIG. 12b

FIG. 13